# EUROPEAN PATENT APPLICATION

(11) **EP 4 117 041 A1**
(43) Date of publication of application: **11.01.2023**
(21) Application number: 21184134.1
(22) Date of filing: 06.07.2021
(51) Int. Cl.: H01L 29/205, H01L 29/267, H01L 29/778, H01L 29/20

(54) **SEMICONDUCTOR STRUCTURE WITH BARRIER LAYER COMPRISING INDIUM ALUMINIUM NITRIDE AND METHOD OF GROWING THEREOF**

(71) Applicant: Soitec Belgium, 3500 Hasselt (BE)
(72) Inventor: Derluyn, Joff, 3500 Hasselt (BE); Kandaswamy, Prem Kumar, 3500 Hasselt (BE); Petersen Barbosa Lima, Lucas, 3500 Hasselt (BE)
(74) Representative: IP HILLS NV

(57) **Abstract**

A semiconductor structure (1) comprising:
- a substrate (100);
- an epitaxial III-N semiconductor layer stack (200) on top of said substrate (100), said epitaxial III-N semiconductor layer stack (200) comprising:
∘ a first active III-N layer (201);
∘ a spacer layer (202) on top of said first active III-N layer (201);
∘ a diffusion barrier layer (203) on top of said spacer layer (202);
∘ a second active III-N layer (204) on top of said diffusion barrier layer (203),

wherein said second active III-N layer (204) comprises Indium Aluminium Nitride;
with a two dimensional Electron Gas (20) between said first active III-N layer (201) and said second active III-N layer (204);
and wherein said diffusion barrier layer (203) comprises an Aluminium mole fraction lower than 0.20.

## Description

### Technical Field

The present invention generally relates, amongst others, to a semiconductor structure comprising an InAIN barrier layer and to a method of growing thereof. More particularly, it relates to a semiconductor structure comprising an InAIN barrier layer demonstrating improved mobility and sheet resistance and to a method of growing thereof.

### Background

GaN-based heterostructures demonstrate high electron velocity and high critical electric field, making them interesting for high-power and high-frequency applications. For example, AlGaN/GaN heterostructures are conventionally used for the manufacturing of field effect transistors also called FETs. In this structure, a two dimensional electron gas, also referred to as 2DEG, is generated by the spontaneous and piezoelectric polarization between AIGaN and GaN.

Increasing the density of the two dimensional electron gas is effective for improving device performance. To increase the density of the two dimensional electron gas, the Aluminium content of the AIGaN barriers should be increased. However, AIGaN with a high Aluminium content is largely strained with respect to GaN. The large strain affects the reliability of devices manufactured from these GaN-based heterostructures.

Ternary InAIN layers have the potential to replace conventional AIGaN as the barrier layer. Ternary InAIN can be lattice matched to GaN for a composition of 17% Indium and 83% Aluminium. A lattice matched InAIN/GaN heterostructure provides a high-density two dimensional electron gas due to the difference in spontaneous polarization at the interface between the InAIN barrier layer and GaN, without any doping. For example, applications in photonics span from the manufacturing of blue and green light-emitting diodes to laser diodes within a broad range of wavelengths. Applications in electronics relate for example to high electron mobility transistors for high-power, high-frequency and/or high temperature devices. Using InAIN as a barrier layer lattice matched to GaN minimizes the effects of misfit-induced defects in Nitride heterostructures devices, giving low strain and low-defect density heteroepitaxial interfaces while providing very high sheet carrier densities. To enhance electron mobility further, an AIN ultrathin layer may be used as a conventional spacer layer between the InAIN barrier layer and the GaN channel layer, thereby forming InAIN/AIN/GaN heterostructures. The electron mobility depends on the abruptness of the interface between GaN and AIN spacer as well as on the quality of the spacer layer itself in terms of compositional uniformity and crystal quality.

Notwithstanding the potential high quality of the manufactured devices, the growth of such structures is not easy to control. Indeed, the growth of InAIN is complicated by the thermal inhibition of the incorporation of Indium into the solid phase at high temperature. In other words, the growth of InAIN films is challenging due to the different optimum growth temperatures of its binary antecedents, InN and AIN: InN dissociates at temperatures above 450°C, whereas AIN must be grown over 1000°C to obtain good quality crystal films.

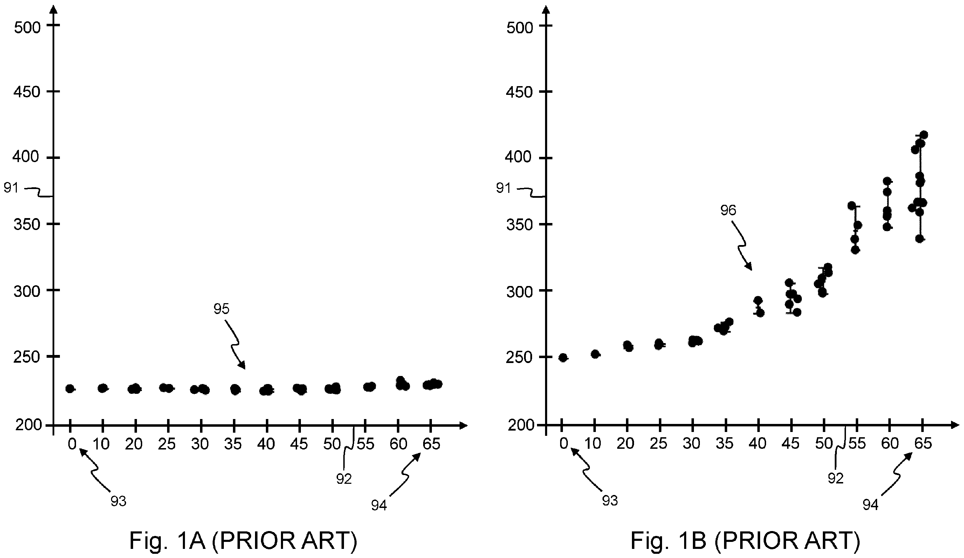

Figs. 1A and 1B illustrate the evolution of the sheet resistance 91 of a wafer onto which an InAIN/AIN/GaN heterostructure is epitaxially grown as a function of the rounded radius 92 from the center 93 of the wafer. Point 93 of both figures therefore corresponds to the center of the wafer and point 94 corresponds to the edge of the wafer. Fig. 1A shows the sheet resistance 95 of the wafer as grown and before thermal annealing of the wafer, while Fig. 1B shows the sheet resistance 96 of the same wafer after thermal annealing, for example when the wafer is annealed at 750°C for thirty minutes. The sheet resistance 95 reaches 225Ω/sq along a radius of the wafer before thermal annealing. However, the sheet resistance 96 increases from 250 to 425Ω/sq along a radius of the wafer after thermal annealing. It is clear that the sheet resistance of the wafer 96 after thermal annealing is much higher than the sheet resistance of the wafer 95 before thermal annealing. Submitting the InAIN/AIN/GaN heterostructure to high temperatures, for example during thermal annealing, leads to a degradation of its sheet resistance. Additionally, it can be seen from Fig. 1B that the degradation of the sheet resistance 96 of the InAIN/AIN/GaN heterostructure after thermal annealing is more important close to the edge 94 of the wafer than close to the center 93 of the wafer.

Hall measurements performed on the wafer studied on Figs. 1A and 1B show that it is not the amount of electrons in the 2DEG which degrades during thermal annealing of the wafer. Instead, the Hall measurements indicate a clear reduction in electron mobility which is inversely proportional to the increase of the sheet resistance. This mobility collapse can be explained by the degradation of the spacer layer abruptness and compositional uniformity.

### Summary

It is thus an object of embodiments of the present invention to propose a semiconductor structure and a manufacturing method which do not show the inherent shortcomings of the prior art. More specifically, it is an object of embodiments of the present invention to propose a semiconductor structure with improved thermal stability and improved electron mobility and a manufacturing method thereof.

The scope of protection sought for various embodiments of the invention is set out by the independent claims.

The embodiments and features described in this specification that do not fall within the scope of the independent claims, if any, are to be interpreted as examples useful for understanding various embodiments of the invention.

There is a need for a semiconductor structure for high-power and high frequency applications, wherein the semiconductor structure comprises a barrier layer lattice matched to GaN and demonstrates improved thermal stability and improved electron mobility.

This object is achieved, according to a first example aspect of the present disclosure, by a semiconductor structure comprising:
- a substrate;
- an epitaxial III-N semiconductor layer stack on top of the substrate, the epitaxial III-N semiconductor layer stack comprising:
   ∘ a first active III-N layer;
   ∘ a spacer layer on top of the first active III-N layer;
   ∘ a diffusion barrier layer on top of the spacer layer;
   ∘ a second active III-N layer on top of the diffusion barrier layer, wherein the second active III-N layer comprises Indium Aluminium Nitride;
   with a two dimensional Electron Gas between the first active III-N layer and the second active III-N layer;
and wherein the diffusion barrier layer comprises an Aluminium mole fraction lower than 0.20.

In a prior art semiconductor structure comprising an epitaxial III-N semiconductor layer stack comprising a first active III-N layer, a spacer layer on top of the first active III-N layer and a second active III-N layer comprising Indium Aluminium Nitride on top of the spacer layer, the second active III-N layer comprising Indium Aluminium Nitride is in direct contact with a very tensile strained spacer layer on top of the first active III-N layer. As Indium atoms are larger than the Ga or Al atoms comprised in the first active III-N layer or second active III-N layer, Indium atoms cause a very large local compressive strain in the lattice of the second active III-N layer. During thermal annealing, Indium atoms migrate from the second active III-N layer comprising Indium Aluminium Nitride into at least the spacer layer. In other words, Indium atoms of the second active III-N layer are diffusing or migrating towards the first active III-N layer into at least the spacer layer during thermal annealing, thereby disrupting the compositional uniformity of the spacer layer and smoothening or blurring or softening the interface between spacer layer and first active III-N layer.

The semiconductor structure according to a first example aspect of the present disclosure is suitable for high-power and high-frequency applications. For example, a lattice matched InAIN/GaN heterostructure provides a high-density two dimensional electron gas due to the difference in spontaneous polarization at the interface between the InAIN barrier layer and GaN, without any doping. Using InAIN as a barrier layer lattice matched to the first active III-N layer minimizes the effects of misfit-induced defects in Nitride heterostructures devices, giving low strain and low-defect density heteroepitaxial interfaces while providing very high sheet carrier densities. The spacer layer epitaxially grown between the first active III-N layer and the diffusion barrier layer further enhances the electron mobility of the semiconductor structure.

The diffusion barrier layer epitaxially grown on top of the spacer layer and onto which the second active III-N layer is epitaxially grown prevents the diffusion or the migration of Indium atoms from the second active III-N layer into at least the spacer layer when the semiconductor structure is submitted to high temperatures, such as for example during thermal annealing. Preferably, the diffusion barrier layer prevents the diffusion or the migration of Indium atoms from the second active III-N layer into the spacer layer and the first active III-N layer when the semiconductor structure is submitted to high temperatures, such as for example during thermal annealing. Preferably, the diffusion barrier layer prevents the diffusion or the migration of Indium atoms from the second active III-N layer into the spacer layer and the first active III-N layer and the substrate when the semiconductor structure is submitted to high temperatures, such as for example during thermal annealing.

The diffusion barrier layer thereby guarantees an improved thermal stability, an improved electron mobility and an improved sheet resistance within the semiconductor structure compared to a semiconductor structure comprising an epitaxial III-N semiconductor layer stack without a diffusion barrier layer grown between the spacer layer and the second active III-N layer. In other words, the diffusion barrier layer according to a first example aspect of the present disclosure allows strain mediated diffusion of Indium atoms at least into the spacer layer of the semiconductor structure.

In the context of the present disclosure, the mole fraction or molar fraction is defined as unit of the amount of a constituent expressed in moles, divided by the total amount of all constituents in a mixture also expressed in moles. According to a first example aspect of the present disclosure, the diffusion barrier layer comprises an Aluminium mole fraction lower than 0.20, such as for example 0.19, 0.18, 0.17, 0.16, 0.15, 0.14, 0.13, 0.12, 0.11, 0.10, etc. In other words, the Aluminium content of the diffusion barrier layer is within the range of 0 to 20%. The content of Aluminium in a layer is defined as the ratio between the number of Aluminium atoms in the layer on the one hand and the total number of all Group III atoms in the layer on the other hand. According to a first example aspect of the present disclosure, the diffusion barrier layer does not comprise Indium.

In the context of the present disclosure, for example, the second active III-N layer is an electron-inducing barrier layer and comprises Indium Aluminium Nitride with an Indium mole fraction for example lower than 0.22. In the context of the present disclosure, for example, the second active III-N layer is an electron-inducing barrier layer and comprises Indium Aluminium Nitride with an Indium mole fraction for example of 0.17 or of 0.18. A second active III-N layer comprising an Indium mole fraction of 0.17 and an Aluminium mole fraction of 0.83 is for example lattice matched to GaN. Preferably, the second active III-N layer is an electron-inducing barrier layer and comprises Indium Aluminium Nitride with an Indium mole fraction for example within the range of 0.14 to 0.22. In an example embodiment, the Indium Aluminium Nitride of the second active III-N layer comprises an Aluminium mole fraction of 0.80 when the Indium Aluminium Nitride comprises an Indium mole fraction of 0.20. In another example embodiment, the Indium Aluminium Nitride of the second active III-N layer comprises an Aluminium mole fraction of 0.86 when the Indium Aluminium Nitride comprises an Indium mole fraction of 0.14. In other words, the Indium Aluminium Nitride of the second active III-N layer for example comprises an Aluminium mole fraction within the range of 0.80 to 0.86. This way, the second active III-N layer is compressive with respect to the first active III-N layer while the first active III-N layer is tensile with an Indium mole fraction of 0.20 or 0.21. Alternatively, the second active III-N layer is an electron-inducing barrier layer and comprises Indium Aluminium Gallium Nitride, with for example a Gallium mole fraction going up to 0.20.

The epitaxial III-N semiconductor layer stack comprises an epitaxial active layer which comprises the first active III-N layer, the spacer layer, the diffusion barrier layer and the second active III-N layer. The epitaxial active layer is formed in-situ by epitaxial growth in a metal-organic chemical vapour deposition epitaxial chamber, also referred to as MOCVD, or in a metal-organic vapour phase epitaxial chamber, also referred to as MOVPE, or in a molecular beam epitaxial chamber, also referred to as MBE, or in a chemical beam epitaxial chamber, also referred to as CBE.

The semiconductor structure can be formed by epitaxial growth by metal-organic chemical vapour deposition (MOCVD) or metal-organic vapour phase epitaxy (MOVPE) or be molecular beam epitaxy (MBE) or chemical beam epitaxy (CBE). In the MOVPE or in the MOCVD process, the epitaxial III-N semiconductor layer stack is epitaxially grown on a substrate, typically at pressures for example comprised between 5 mBar and 1 Bar and typically at temperatures for example comprised between 600°C and 1200°C. The precursor materials can be but are not limited to ammonia (NH₃) for nitrogen; tri-methyl-Ga (TMGa) or tri-ethyl-Ga (TEGa) for Gallium, tri-methyl-AI (TMAI) or tri-ethyl-AI (TEAI) for Aluminium; tri-methyl-Indium (TMIn) for Indium; and Silane (SiH₄) or disilane (SiH₃)₂ for Silicon.

Group III-Nitride refers to semiconductor compounds formed between elements in Group III of the periodic table, for example Boron, also referred to as B, Aluminium, also referred to as Al, Gallium, also referred to as Ga, Indium, also referred to as In, and Nitrogen, also referred to as N. Example of binary Group III-Nitride compounds are GaN, AIN, BN, etc.. Group III-Nitride also refers to ternary and quaternary compounds such as for example InAIN, AIGaN, InAIGaN, etc.

A two-dimensional electron gas is a gas of electrons free to move in two dimensions, but tightly confined in the first. This tight confinement leads to quantized energy levels for motion in that direction. The electrons appear to be a 2D sheet embedded in a 3D world. A device of particular interest for high power and/or high frequency applications is the high electron mobility transistor, also referred to as HEMT. According to the present invention, the passivation stack is formed between the epitaxial III-V semiconductor layer stack and the gate. The passivation stack may be formed only under the gate and may serve additionally as gate dielectric. Alternatively, the passivation stack may be formed on top of the epitaxial III-V semiconductor layer stack and may fully cover the epitaxial III-V semiconductor layer stack. Alternatively, the passivation stack may be formed on top of the epitaxial III-V semiconductor layer stack and partially cover the surface of the epitaxial III-V semiconductor layer stack, for example it may be formed in the ungated area between the source and the drain of the high mobility electron transistor according to the present invention, where it serves as passivation and prevents the depletion of the underlying 2DEG.

According to example embodiments, the diffusion barrier layer comprises one or more of the following:
- Gallium Nitride;
- Silicon carbide;
- Silicon Nitride;
- Aluminium Gallium Nitride.

The diffusion barrier layer comprising GaN in the semiconductor structure according to a first example aspect of the present disclosure demonstrates the largest compressive strain as it lowers the tensile strain component. A diffusion barrier layer comprising AIGaN in the semiconductor structure according to a first example aspect of the present disclosure demonstrates a higher tensile strain component than a diffusion barrier layer comprising GaN.

According to example embodiments, the diffusion barrier layer is a monolayer.

This way, the bottom of the conduction band of the diffusion barrier layer at the interface with the second active III-N layer does not drop below the Fermi level as the conduction band discontinuity is not large and as the charge induced by the spontaneous polarization of the second active III-N layer is not large. Additionally, the Aluminium content of the diffusion barrier layer is constant over the monolayer.

According to example embodiments, a thickness of the diffusion barrier layer is lower than 1.5nm.

This way, the bottom of the conduction band of the diffusion barrier layer at the interface with the second active III-N layer does not drop below the Fermi level as the conduction band discontinuity is not large and as the charge induced by the spontaneous polarization of the second active III-N layer is not large. For example, the diffusion barrier layer is 1nm thick or 0.5nm thick. Additionally, the Aluminium content of the diffusion barrier layer is constant over the thickness of the diffusion barrier layer.

According to example embodiments, the first active III-N layer comprises Gallium Nitride.

Preferably, the first active III-N layer is grown epitaxially and comprises pure Gallium Nitride, preferably a monolayer of Gallium Nitride.

According to example embodiments, the spacer layer comprises Aluminium Nitride.

Preferably, the spacer layer is grown epitaxially and comprises pure aluminum Nitride.

According to example embodiments, a thickness of the spacer layer is lower than 2nm.

This way, the spacer layer is kept thin enough to minimize the roughness of the spacer layer. With minimized roughness, the spacer layer prevents the diffusion or the migration of Indium atoms into at least the first active III-N layer. This way, the thermal stability of the semiconductor structure is further improved. In other words, the thinner the spacer layer, the better the thermal stability of the semiconductor structure. Preferably, the thickness of the spacer layer is comprised between 0.5nm and 1.5nm. Even more preferably, the thickness of the spacer layer is comprised between 0.8nm and 1nm.

The substrate of the semiconductor structure according to a first example aspect of the present disclosure comprises one or more of the following: Si, Silicon-On-Insulator, Silicon Carbide, Sapphire. This way, the manufacturing of the semiconductor structure according to a first example aspect of the present disclosure is compatible with existing manufacturing techniques developed for the complementary metal-oxide-semiconductor technology and processes. In other words, the manufacturing of the semiconductor structure is CMOS-compatible as present features and present process steps can be integrated therein without much additional effort. This reduces the complexity and the costs associated with manufacturing such a semiconductor structure. Preferably, the substrate is a Si substrate, such as a <111> Si substrate, and combinations of thereof, and substrates comprising initial layers, such as a stack of layers. Alternatively, the substrate of the semiconductor structure comprises Germanium, also referred to as Ge, or Ge-On-Insulator, etc.. Alternatively, the substrate of the semiconductor structure comprises a free-standing GaN substrate, a free-standing AIN substrate.

Alternatively, the epitaxial III-N semiconductor layer stack comprises an epitaxially grown buffer layer grown between the substrate and the first active III-N layer. The buffer layer may be of a different nature than the substrate, in that for instance the bandgap of the substrate and buffer layer are relatively far apart (such as 1.1 eV and 6.2 eV respectively), in the sense that the buffer layer has a high bandgap, in order to provide present characteristics, such as high break down voltage, e.g. larger than 250 V, preferably larger than 500 V, even more preferably larger than 1000 V, such as larger than 2000 V, or even much larger. The buffer layer is in an example a III-V buffer layer with a high bandgap. Therein III refers to Group III elements, now being Group 13 and Group 3 elements, such as B, Al, Ga, In, TI, Sc, Y and Lanthanide and Actinide series. Therein V refers to Group V elements, now being N Group elements, such as N, P, As, Sb, Bi. The buffer layer comprises a stack of layers, in an example typically the first one being a nucleation layer.

Alternatively, the semiconductor structure further comprises a Silicon base wafer, the buffer layer stack being separated from the Silicon base wafer by means of an AIN nucleation layer which is in direct contact with the Silicon base wafer and the buffer layer. Alternatively, a total thickness of the nucleation layer is within the range between 10 nm and 200 nm. According to preferred embodiments, the buffer layer stack has an upper buffer layer and a lower buffer layer, the lower buffer layer being in direct contact with the AIN nucleation layer and the upper buffer layer being in direct contact with the active layer. According to preferred embodiments, a total thickness of the buffer layer stack is within the range between 500 nm and 10 µm. The layers of the buffer layer stack are preferably all (In)AIGaN layers.

According to example embodiments, the semiconductor structure further comprises a passivation layer on top of the second active III-N layer.

The passivation layer is formed in-situ with the formation of the epitaxial III-N semiconductor layer stack. This way, a fully crystalline passivation layer is epitaxially grown on top of the epitaxial III-N semiconductor layer stack. Alternatively, a partially crystalline passivation layer is epitaxially grown on top of the epitaxial III-N semiconductor layer stack. The passivation layer may also be formed by ex-situ deposition with the help of epitaxy tools like atomic layer deposition, also referred to as ALD, chemical vapor deposition, also referred to as CVD, or physical vapor deposition, also referred to as PVD. Alternatively, the passivation layer may be formed by in-situ deposition in a MOCVD or a MBE chamber. Alternatively, the passivation layer may be formed by depositing an amorphous film of the same material and recrystallizing it using thermal anneal. The passivation layer on top of the second active III-N layer for example comprises Gallium Nitride. Alternatively, the passivation layer on top of the second active III-N layer comprises Gallium Nitride and Silicon Nitride.

According to example embodiments, the passivation layer comprises Silicon Nitride and/or an oxide layer.

This way, the passivation layer of the semiconductor structure according to a first example aspect of the present disclosure comprises Silicon Nitride and/or an oxide layer which acts as a passivation layer. The oxide layer exhibits an electrically clean interface to the second active III-N layer, a high dielectric constant to maximize electrostatic coupling between electrical contacts formed onto the semiconductor structure and the 2DEG which results in an increase of for example the transconductance of high electron mobility transistors manufactured with the semiconductor structure and a sufficient thickness to avoid dielectric breakdown and leakage by quantum tunneling.

According to a second example aspect, there is provided a method for manufacturing a semiconductor structure, wherein the method comprises the steps of:
- providing a substrate;
- providing an epitaxial III-N semiconductor layer stack on top of the substrate; wherein providing the epitaxial III-N semiconductor layer stack comprises the steps of:
   ∘ providing a first active III-N layer;
   ∘ providing a spacer layer on top of the first active III-N layer;
   ∘ providing a diffusion barrier layer on top of the spacer layer, wherein the diffusion barrier layer comprises an Aluminium mole fraction lower than 0.20;
   ∘ providing a second active III-N layer on top of the diffusion barrier layer; wherein the second active III-N layer comprises Indium Aluminium Nitride;
   thereby forming a two dimensional Electron Gas between the first active III-N layer and the second active III-N layer.

The method of manufacturing a semiconductor structure according to a second example aspect of the present disclosure is suitable for manufacturing devices for high-power and high-frequency applications. For example, manufacturing a device comprising a lattice matched InAIN/GaN heterostructure provides a high-density two dimensional electron gas due to the difference in spontaneous polarization at the interface between the InAIN barrier layer and GaN, without any doping. Using InAIN as a barrier layer lattice matched to the first active III-N layer minimizes the effects of misfit-induced defects in Nitride heterostructures devices, giving low strain and low-defect density heteroepitaxial interfaces while providing very high sheet carrier densities. The spacer layer epitaxially grown between the first active III-N layer and the diffusion barrier layer further enhances the electron mobility of the semiconductor structure.

The diffusion barrier layer epitaxially grown on top of the spacer layer and onto which the second active III-N layer is epitaxially grown prevents the diffusion or the migration of Indium atoms from the second active III-N layer into at least the spacer layer when the semiconductor structure is submitted to high temperatures, such as for example during thermal annealing. Preferably, the diffusion barrier layer prevents the diffusion or the migration of Indium atoms from the second active III-N layer into the spacer layer and the first active III-N layer when the semiconductor structure is submitted to high temperatures, such as for example during thermal annealing. Preferably, the diffusion barrier layer prevents the diffusion or the migration of Indium atoms from the second active III-N layer into the spacer layer and the first active III-N layer and the substrate when the semiconductor structure is submitted to high temperatures, such as for example during thermal annealing.

The diffusion barrier layer thereby guarantees an improved thermal stability, an improved electron mobility and an improved sheet resistance within the semiconductor structure compared to a semiconductor structure comprising an epitaxial III-N semiconductor layer stack without a diffusion barrier layer grown between the spacer layer and the second active III-N layer. In other words, the diffusion barrier layer according to a first example aspect of the present disclosure allows strain mediated diffusion of Indium atoms at least into the spacer layer of the semiconductor structure.

Preferably, providing a first active III-N layer corresponds to growing a monolayer of pure Gallium Nitride. Preferably, providing a spacer layer on top of the first active III-N layer corresponds to growing a monolayer of pure aluminum Nitride.

According to example embodiments, for providing the diffusion barrier layer on top of the spacer layer a surface temperature is used which is in the range of 725°C to 825°C.

This way, with the method of manufacturing a semiconductor structure according to a second example aspect of the present disclosure, there is no growth interruption between the growth of the diffusion barrier layer and the growth of the second active III-N layer. In other words, the diffusion barrier layer and the second active III-N layer are both grown under the same processing conditions. The growth of the diffusion barrier layer is performed so that a temperature of the actual growth surface of the diffusion barrier layer being formed on top of the spacer is within the range of 725°C to 825°C. In other words, a temperature of the surface of the spacer layer before the diffusion barrier layer is grown is in the range of 725°C to 825°C and a temperature of the growth surface of the diffusion barrier layer opposite to the surface of the diffusion barrier layer in contact with the spacer layer is in the range of 725°C to 825°C during the growth of the diffusion barrier layer on top of the spacer layer. Alternatively, the diffusion barrier layer is grown on top of the spacer layer at a temperature higher than 825°C. In the content of the present disclosure, the spacer layer may be grown at a temperature lower than 800°C or at a temperature higher than 800°C.

### Brief Description of the Drawings

Some example embodiments will now be described with reference to the accompanying drawings.
Fig. 1 depicts an example embodiment of a measurement of the sheet resistance of a semiconductor structure according to the prior art.
Fig. 2 depicts an example embodiment of a semiconductor structure according to the present disclosure.
Fig. 3 depicts an example embodiment of a measurement of the sheet resistance of a semiconductor structure according to the present disclosure.
Fig. 4 depicts an example embodiment of a method for manufacturing a semiconductor structure according to the present disclosure.

### Detailed Description of Embodiment(s)

Figs. 1A and 1B illustrate an example embodiment of a measurement of the sheet resistance of a semiconductor structure according to the prior art. Figs. 1A and 1B illustrate the evolution of the sheet resistance 91 of a wafer onto which an InAIN/AIN/GaN heterostructure is epitaxially grown as a function of the rounded radius 92 from the center 93 of the wafer. Point 93 of both figures therefore corresponds to the center of the wafer and point 94 corresponds to the edge of the wafer. Fig. 1A shows the sheet resistance 95 of the wafer as grown and before thermal annealing of the wafer, while Fig. 1B shows the sheet resistance 96 of the same wafer after thermal annealing, for example when the wafer is annealed at 750°C for thirty minutes. The sheet resistance 95 reaches 225Ω/sq along a radius of the wafer before thermal annealing. However, the sheet resistance 96 increases from 250 to 425Ω/sq along a radius of the wafer after thermal annealing. It is clear that the sheet resistance of the wafer 96 after thermal annealing is much higher than the sheet resistance of the wafer 95 before thermal annealing. Submitting the InAIN/AIN/GaN heterostructure to high temperatures, for example during thermal annealing, leads to a degradation of its sheet resistance. Additionally, it can be seen from Fig. 1B that the degradation of the sheet resistance 96 of the InAIN/AIN/GaN heterostructure after thermal annealing is more important close to the edge 94 of the wafer than close to the center 93 of the wafer.

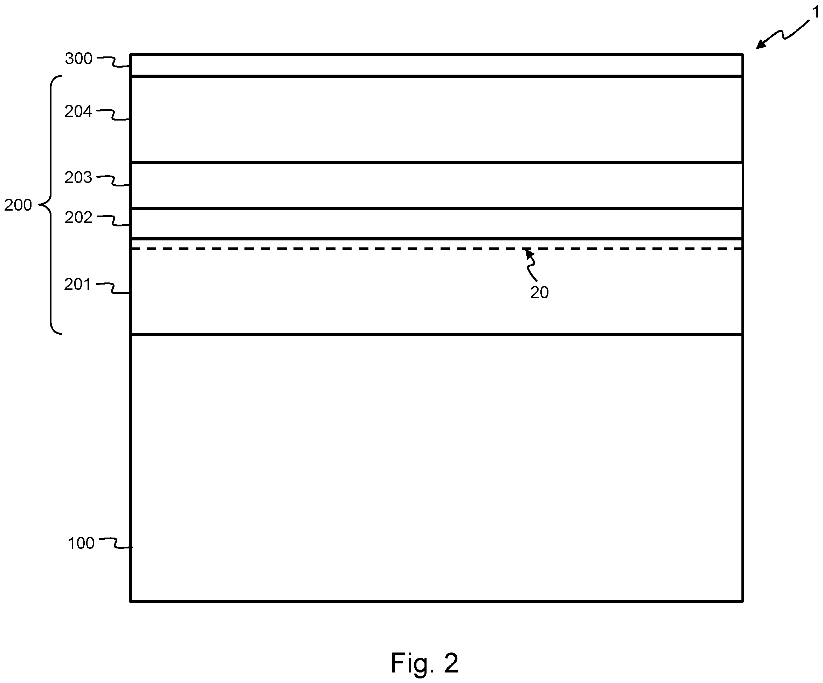

Fig. 2 illustrates an example embodiment of a semiconductor structure 1 according to the present disclosure. The semiconductor structure 1 comprises a substrate 100 and an epitaxial III-N semiconductor layer stack 200 on top of the substrate 100. According to an alternative embodiment, the epitaxial III-N semiconductor layer stack comprises an epitaxially grown buffer layer grown between the substrate and the first active III-N layer. The epitaxial III-N semiconductor layer stack 200 comprises a first active III-N layer 201, a spacer layer 202 grown on top of the first active III-N layer 201, a diffusion barrier layer 203 grown on top of the space layer 202, and a second active III-N layer 204 grown on top of the diffusion barrier layer 203. The second active III-N layer 204 comprises Indium Aluminium Nitride. A two dimensional Electron Gas 20 is formed between the first active III-N layer 201 and the second active III-N layer 204. The diffusion barrier layer 203 comprises an Aluminium mole fraction lower than 0.20. According to optional example embodiments, the diffusion barrier layer 203 comprises one or more of the following: Gallium Nitride, Silicon Carbide, Silicon Nitride, Aluminium Gallium Nitride. Optionally, the diffusion barrier layer 203 is a monolayer. According to an optional example embodiment, a thickness of the diffusion barrier layer 203 is lower than 1.5nm. According to an optional example embodiment, the first active III-N layer 201 comprises Gallium Nitride. According to an optional example embodiment, the spacer layer 202 comprises Aluminium Nitride. According to an optional example embodiment, the spacer layer 202 is less than 2nm thick. According to an optional example embodiment, the semiconductor structure 1 further comprises a passivation layer 300 formed on top of the second active III-N structure 204. According to an optional example embodiment, the passivation layer 300 comprises Silicon Nitride and/or an oxide layer. According to an alternative embodiment, the passivation layer 300 comprises Gallium Nitride. According to a further alternative embodiment, the passivation layer 300 comprises Gallium Nitride and Silicon Nitride.

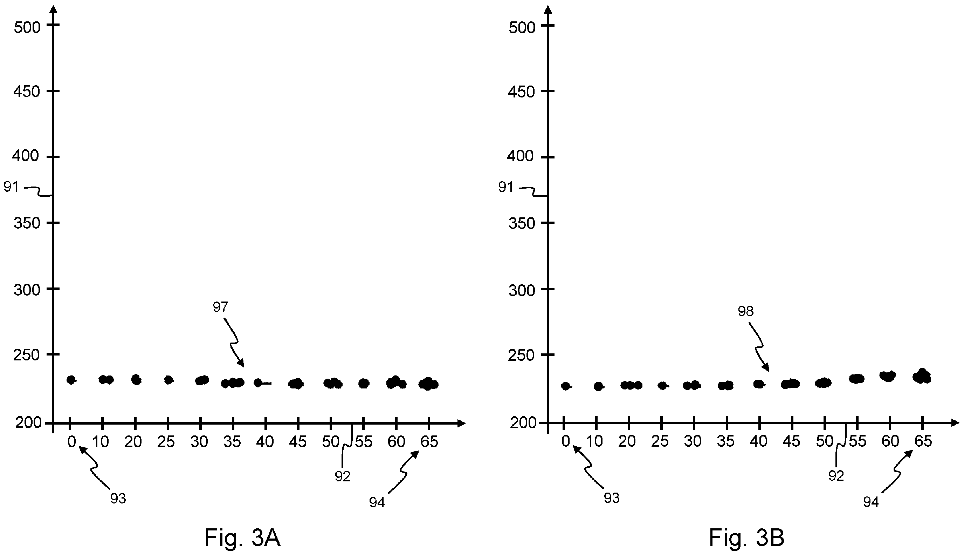

Figs. 3A and 3B illustrate an example embodiment of a measurement of the sheet resistance of a semiconductor structure 1 according to the present disclosure. Figs. 3A and 3B illustrate the evolution of the sheet resistance 91 of a wafer onto which an InAIN/AIN/GaN semiconductor heterostructure 1 according to the present disclosure is epitaxially grown as a function of the rounded radius 92 from the center 93 of the wafer. Point 93 of both figures therefore corresponds to the center of the wafer and point 94 corresponds to the edge of the wafer. Fig. 3A shows the sheet resistance 97 of the semiconductor structure 1 according to the present disclosure as grown and before thermal annealing of the wafer, while Fig. 3B shows the sheet resistance 97 of the same semiconductor structure 1 according to the present disclosure after thermal annealing, for example when the semiconductor structure 1 according to the present disclosure is annealed at 750°C for thirty minutes. The sheet resistance 97 is in the range of 225 Ω/sq to 230Ω/sq along a radius of the wafer before thermal annealing. The sheet resistance 98 is also in the range of 225 Ω/sq to 230Ω/sq along a radius of the wafer after thermal annealing. It is clear that the sheet resistance of the wafer 98 onto which the semiconductor structure 1 according to the present disclosure is grown does not change after thermal annealing compared to before thermal annealing. In other words, submitting the semiconductor structure 1 according to the present disclosure to elevated temperatures during a certain amount of time, for example during thermal annealing, does not lead to a degradation of its sheet resistance. Additionally, it can be seen from Fig. 3B that there is no difference in the values of the sheet resistance 98 of the semiconductor structure 1 according to the present disclosure after thermal annealing between the edge 94 of the wafer or close to the center 93 of the wafer.

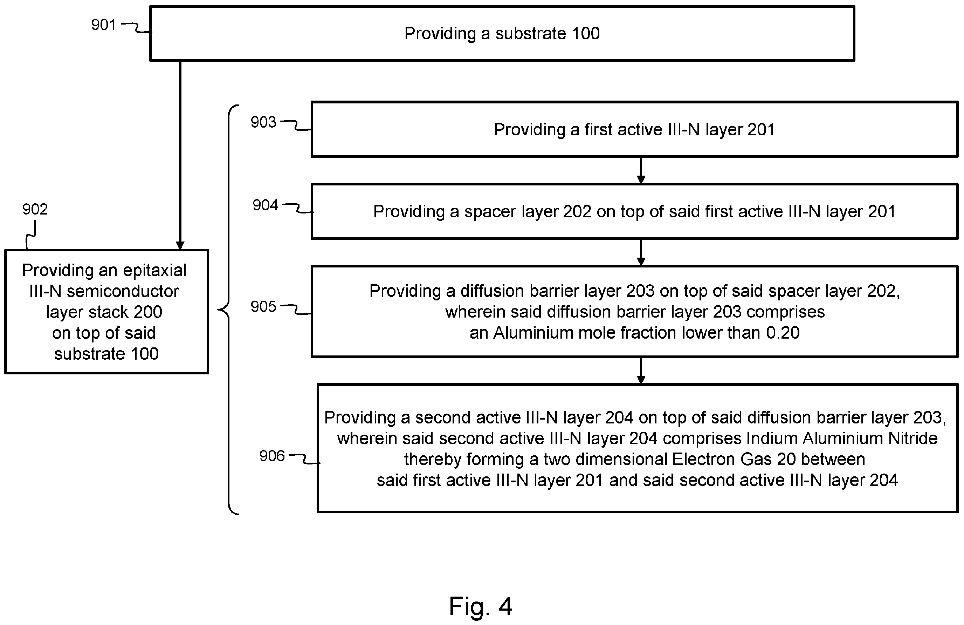

Fig. 4 illustrates an example embodiment of a method of manufacturing a semiconductor structure according to the present disclosure. In a first main step 901, the method comprises providing a substrate 100. In a second main step 902 consecutive to the first step 901, the method comprises providing an epitaxial III-N semiconductor layer stack 200 on top of the substrate 100. The method step of providing an epitaxial III-N semiconductor layer stack 200 on top of the substrate 100 comprises a first step 903 of providing a first active III-N layer 201. The method step of providing an epitaxial III-N semiconductor layer stack 200 on top of the substrate 100 further comprises a second step 904 consecutive to the first step 903 of providing a spacer layer 202 on top of the first active III-N layer 201. The method step of providing an epitaxial III-N semiconductor layer stack 200 on top of the substrate 100 further comprises a third step 905 consecutive to the second step 904 of providing a diffusion barrier layer 203 on top of the spacer layer 202, wherein the diffusion barrier layer 203 comprises an Aluminium mole fraction lower than 0.20. The method step of providing an epitaxial III-N semiconductor layer stack 200 on top of the substrate 100 further comprises a fourth step 906 consecutive to the third step 905 of providing a second active III-N layer 204 on top of said diffusion barrier layer 203, wherein said second active III-N layer 204 comprises Indium Aluminium Nitride, thereby forming a two dimensional Electron Gas 20 between said first active III-N layer 201 and said second active III-N layer 204. According to an optional example embodiment, for the method step of providing the diffusion barrier layer 203 on top of the spacer layer a surface temperature is used which is in the range of 725°C to 825°C.

Although the present invention has been illustrated by reference to specific embodiments, it will be apparent to those skilled in the art that the invention is not limited to the details of the foregoing illustrative embodiments, and that the present invention may be embodied with various changes and modifications without departing from the scope thereof. The present embodiments are therefore to be considered in all respects as illustrative and not restrictive, the scope of the invention being indicated by the appended claims rather than by the foregoing description, and all changes which come within the scope of the claims are therefore intended to be embraced therein.

It will furthermore be understood by the reader of this patent application that the words "comprising" or "comprise" do not exclude other elements or steps, that the words "a" or "an" do not exclude a plurality, and that a single element, such as a computer system, a processor, or another integrated unit may fulfil the functions of several means recited in the claims. Any reference signs in the claims shall not be construed as limiting the respective claims concerned. The terms "first", "second", third", "a", "b", "c", and the like, when used in the description or in the claims are introduced to distinguish between similar elements or steps and are not necessarily describing a sequential or chronological order. Similarly, the terms "top", "bottom", "over", "under", and the like are introduced for descriptive purposes and not necessarily to denote relative positions. It is to be understood that the terms so used are interchangeable under appropriate circumstances and embodiments of the invention are capable of operating according to the present invention in other sequences, or in orientations different from the one(s) described or illustrated above.

## Claims

1. A semiconductor structure (1) comprising:
- a substrate (100);
- an epitaxial III-N semiconductor layer stack (200) on top of said substrate (100), said epitaxial III-N semiconductor layer stack (200) comprising:
∘ a first active III-N layer (201);
∘ a spacer layer (202) on top of said first active III-N layer (201);
∘ a diffusion barrier layer (203) on top of said spacer layer (202);
∘ a second active III-N layer (204) on top of said diffusion barrier layer (203), wherein said second active III-N layer (204) comprises Indium Aluminium Nitride;
with a two dimensional Electron Gas (20) between said first active III-N layer (201) and said second active III-N layer (204);
and wherein said diffusion barrier layer (203) comprises an Aluminium mole fraction lower than 0.20.

2. The semiconductor structure (1) according to claim 1, wherein said diffusion barrier layer (203) comprises one or more of the following:
- Gallium Nitride;
- Silicon carbide;
- Silicon Nitride;
- Aluminium Gallium Nitride.

3. The semiconductor structure (1) according to any of the preceding claims, wherein said diffusion barrier layer (203) is a monolayer.

4. The semiconductor structure (1) according to any of the preceding claims, wherein a thickness of said diffusion barrier layer (203) is lower than 1.5nm.

5. The semiconductor structure (1) according to any of the preceding claims, wherein said first active III-N layer (201) comprises Gallium Nitride.

6. The semiconductor structure (1) according to any of the preceding claims, wherein said spacer layer (202) comprises Aluminium Nitride.

7. The semiconductor structure (1) according to any of the preceding claims, wherein a thickness of said spacer layer (202) is lower than 2nm.

8. The semiconductor structure (1) according to any of the preceding claims, wherein said semiconductor structure (1) further comprises a passivation layer (300) on top of said second active III-N layer (204).

9. The semiconductor structure (1) according to claim 8, wherein said passivation layer (300) comprises Silicon Nitride and/or an oxide layer.

10. A method for manufacturing a semiconductor structure (1), wherein said method comprises the steps of:
- providing a substrate (100);
- providing an epitaxial III-N semiconductor layer stack (200) on top of said substrate (100); wherein providing said epitaxial III-N semiconductor layer stack (200) comprises the steps of:
∘ providing a first active III-N layer (201);
∘ providing a spacer layer (202) on top of said first active III-N layer (201);
∘ providing a diffusion barrier layer (203) on top of said spacer layer (202), wherein said diffusion barrier layer (203) comprises an Aluminium mole fraction lower than 0.20;
∘ providing a second active III-N layer (204) on top of said diffusion barrier layer (203); wherein said second active III-N layer (204) comprises Indium Aluminium Nitride;
thereby forming a two dimensional Electron Gas between said first active III-N layer (201) and said second active III-N layer (204).

11. The method according to claim 10, wherein for providing said diffusion barrier layer (203) on top of said spacer layer (202) a surface temperature is used which is in the range of 725°C to 825°C.
